# EUROPEAN PATENT APPLICATION

(11) **EP 4 770 283 A2**
(43) Date of publication of application: **01.07.2026**
(21) Application number: 25198147.8
(22) Date of filing: 26.08.2025
(51) Int. Cl.: H05K 1/02, G02F 1/1345, H05K 1/14, H10K 59/80

(54) **DISPLAY DEVICE AND DISPLAY PANEL**

(30) Priority: 30.12.2024 KR 20240200806
(71) Applicant: LG Display Co., Ltd., Seoul, 07336 (KR)
(72) Inventor: JANG, Gyu Bum, 10845 Paju-si, Gyeonggi-do (KR); SONG, Min Gyu, 10845 Paju-si, Gyeonggi-do (KR); KIM, Hoe Yong, 10845 Paju-si, Gyeonggi-do (KR); YU, Myeong Hyeon, 10845 Paju-si, Gyeonggi-do (KR); KIM, Tae Hwan, 10845 Paju-si, Gyeonggi-do (KR)
(74) Representative: Viering, Jentschura & Partner mbB Patent- und Rechtsanwälte

(57) **Abstract**

Disclosed are a display device and a display panel (100). The display device may include a display panel (100) and a plurality of circuit boards (200) connected to the display panel (100). The display panel (100) may include an electrode pattern (110) disposed on a substrate (10) and a pad (120) electrically connected to the circuit boards (200). The pad (120) may include a first pad (120a) arranged on the electrode pattern (110) to overlap the electrode pattern (110). The first pad (120a) may include a plurality of first pad wires (121) spaced apart from one another. This structure may allow for improved electrical connection and heat dissipation in regions where wire concentration is high.

## Description

### BACKGROUND

### Technical Field

The present disclosure relates to a display panel and a display device including the same, more particularly, for example, without limitation, to a display panel that is structurally improved to disperse and/or reduce heat generated in a bottleneck where a plurality of wires are densely packed and a display device including the same.

### Description of the Related Art

Display devices are widely used as display screens of various electronic devices such as mobile communication terminal, electronic notebook, electronic book, portable multimedia player (PMP), navigation aid, ultra mobile PC (UMPC), mobile phone, tablet personal computer (PC), watch phone, electronic pad, wearable device, portable information device, navigation aid, vehicle control display device, television, laptop, and monitor.

Such a display device may include a display panel and a plurality of circuit boards connected to the display panel, and the circuit boards may be attached to the pad of the display panel.

The description provided in the description of the related art section should not be assumed to be prior art merely because it is mentioned in or associated with the description of the related art section. The description of the related art section may include information that describes one or more aspects of the subject technology, and the description in this section does not limit the disclosure.

### BRIEF SUMMARY

In certain display panel configurations, a plurality of pads may be arranged within a limited region, for example, spaced apart along an edge of the display panel. In such cases, a large number of wires extending throughout the panel may become concentrated in areas near the pads, resulting in a densely packed region that can restrict current flow, thereby forming a bottleneck.

In the bottleneck region, increased current density may occur due to the high concentration of wires, which may lead to elevated heat generation relative to other areas of the panel. This localized thermal accumulation may result in physical or operational damage to the display panel.

Bottlenecks of this type may also arise in regions other than those immediately adjacent to the pads, wherever multiple wires are densely arranged. Accordingly, there exists a need for a display panel structure that is capable of reducing or dispersing heat generated in such densely wired areas.

In particular, the disclosure addresses the problem of localized heat buildup in display panels, particularly in regions where many signal wires are concentrated near the connection pads. This excessive heat can lead to performance degradation or physical damage to the display components. To manage this issue, structural modifications are introduced to improve heat dispersion and reduce thermal stress in these critical areas.

One approach involves placing a metal electrode pattern beneath the densely arranged pad wires. This pattern acts as a thermal conductor, spreading heat across both the width and length of the display panel. The first pad is formed as a group of multiple wires that are spaced apart from one another, rather than as a continuous structure. This configuration reduces mechanical stress during bonding with an anisotropic conductive film and enhances thermal distribution. Additional surface features such as openings or raised portions on the electrode pattern are designed to increase exposure to the ambient environment and support efficient heat release.

The disclosure also includes alignment marks positioned between adjacent pads to separate wire routing paths and reduce local heat accumulation. Furthermore, the electrode pattern is electrically connected to both the circuit board and the cathode electrode, allowing for effective transfer of both electrical signals and thermal energy. These combined design elements improve the thermal stability and operational durability of the display panel.

An exemplary embodiment according to the present disclosure provides a display panel that is structurally improved to disperse and/or reduce heat generated in a bottleneck where a plurality of wires are densely packed, and a display device including the same.

An exemplary embodiment according to the present disclosure provides a display panel that has electrode patterns arranged under a plurality of wires connected to the circuit board for heat dissipation, and a display device including the same.

An exemplary embodiment according to the present disclosure provides a display panel that alleviates the concentration of a plurality of wires through alignment marks, and a display device including the same.

An exemplary embodiment according to the present disclosure provides a display panel that has a heat dissipation structure for improving heat dissipation in the electrode pattern, and a display device including the same.

It should be noted that objects of the present disclosure are not limited to the above-described objects, and other objects of the present disclosure will be apparent to those skilled in the art from the following descriptions. Various embodiments of the present disclosure provide a display device according to claim 1. Further embodiments are described in the dependent claims.

A display device according to an exemplary embodiment of the present disclosure may include a display panel and a plurality of circuit boards connected to the display panel, wherein the display panel may include an electrode pattern disposed on a substrate and a pad electrically connected to the circuit boards, wherein the pad may include a first pad arranged on the electrode pattern to overlap therewith, and wherein the first pad may include a plurality of first pad wires arranged to be spaced apart from each other.

A display device according to an exemplary embodiment of the present disclosure may include a display panel and a plurality of circuit boards connected to the display panel, wherein the display panel may include an electrode pattern arranged on a substrate, a first pad and a second pad electrically connected to the circuit boards, and an alignment mark arranged between the first pad and the second pad, and wherein the first pad may overlap with the electrode pattern.

A display device according to an exemplary embodiment of the present disclosure may include a display panel and a plurality of circuit boards connected to the display panel, wherein the display panel may include an electrode pattern arranged on a substrate, a pad electrically connected to the circuit boards, and a heat dissipator arranged on the electrode pattern, wherein the pad may include a first pad arranged on the electrode pattern to overlap therewith, and wherein the heat dissipator may be arranged adjacent to the first pad.

A display panel according to an exemplary embodiment of the present disclosure may include an electrode pattern disposed on a substrate and a pad electrically connected to circuit boards, wherein the pad may include a first pad arranged on the electrode pattern to overlap therewith, and wherein the first pad may include a plurality of first pad wires arranged to be spaced apart from each other.

A display panel according to an exemplary embodiment of the present disclosure may include an electrode pattern arranged on a substrate, a first pad and a second pad electrically connected to the circuit boards, and an alignment mark arranged between the first pad and the second pad, and wherein the first pad may overlap with the electrode pattern.

A display panel according to an exemplary embodiment of the present disclosure may include an electrode pattern arranged on a substrate, a pad electrically connected to the circuit boards, and a heat dissipator arranged on the electrode pattern, wherein the pad may include a first pad arranged on the electrode pattern to overlap therewith, and wherein the heat dissipator may be arranged adjacent to the first pad.

An exemplary embodiment according to the present disclosure may disperse heat generated from a plurality of wires by using a metal electrode pattern arranged under the plurality of wires connected to the circuit board.

An exemplary embodiment according to the present disclosure may alleviate the concentration of a plurality of wires supplied to the pad through alignment marks.

An exemplary embodiment according to the present disclosure may implement a heat dissipation structure for improving heat dissipation on the electrode pattern by using a plurality of protruding patterns arranged spaced apart from each other.

An exemplary embodiment according to the present disclosure may disperse and/or reduce heat generated in the pad by utilizing at least one of a metal electrode pattern arranged under a plurality of wires, an alignment mark arranged between a plurality of wires supplied to the pad, and a plurality of protruding patterns arranged on the electrode pattern. Accordingly, the durability of the display panel is improved, which may reduce greenhouse gases in the production process.

Objectives to be solved by embodiments are not limited to the objectives described above, and objectives which are not described above will be clearly understood by those skilled in the art from the following descriptions.

### BRIEF DESCRIPTION OF THE SEVERAL VIEWS OF THE DRAWINGS

The above and other objects, features, and advantages of the present disclosure will become more apparent to those of ordinary skill in the art by describing exemplary embodiments thereof in detail with reference to the attached drawings, in which:
FIG. 1 is a diagram illustrating a display device according to an exemplary embodiment of the present disclosure;
FIG. 2 is a cross-sectional view schematically illustrating a display panel according to an exemplary embodiment of the present disclosure;
FIG. 3 is a cross-sectional view showing a cross-sectional structure of the pixel area arranged in the display area of the display panel according to an exemplary embodiment of the present disclosure;
FIG. 4 is a view illustrating the arrangement relationship between the display panel and the circuit board according to an exemplary embodiment of the present disclosure;
FIG. 5 is a view illustrating the arrangement relationship between the pad, circuit board, and adhesive member of the display panel with respect to region A of FIG. 4;
FIG. 6 is an enlarged view showing the electrode pattern and pad arranged on the display panel with respect to region B of FIG. 4;
FIG. 7 is an enlarged view showing region C of FIG. 6;
FIG. 8 is a cross-sectional view taken along line I-I' of FIG. 7;
FIG. 9 is a cross-sectional view taken along line II-II' of FIG. 7;
FIG. 10 is a view illustrating holes of the electrode pattern arranged in the display panel with respect to region C of FIG. 6 according to an exemplary embodiment of the present disclosure;
FIG. 11 is a cross-sectional view taken along line III-III' of FIG. 10;
FIG. 12 is a view illustrating a heat dissipator arranged on the electrode pattern with respect to region B shown in FIG. 4; and
FIG. 13 is a cross-sectional view taken along line IV-IV' in FIG. 12.

The effects of the present disclosure are not limited to the aforementioned effects, and other effects, which are not mentioned above, will be apparently understood to a person having ordinary skill in the art from the following description.

### DETAILED DESCRIPTION

Reference will now be made in detail to embodiments of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

The advantages and features of the present disclosure and methods for accomplishing the same will be more clearly understood from embodiments described below with reference to the accompanying drawings. However, the present disclosure is not limited to the following embodiments but may be implemented in various different forms. Rather, the present embodiments will make the disclosure of the present disclosure complete and allow those skilled in the art to completely comprehend the scope of the present disclosure. The present disclosure is only defined within the scope of the accompanying claims.

The shapes, sizes, dimensions (e.g., length, width, height, thickness, radius, diameter, area, etc.), ratios, angles, numbers of elements, and the like disclosed in the drawings for describing the embodiments of the present disclosure are exemplary, and the present disclosure is not limited to the illustrated items.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

In addition, in describing the present disclosure, if it is determined that the detailed description of the related known technology may unnecessarily obscure the subject matter of the present disclosure, the detailed description thereof will be omitted.

The terms such as "include," "have," "comprise," "contain," "constitute," "make up of," "formed of," and "consist of" used herein are generally intended to allow other components to be added unless the terms are used with the term "only." References to the singular shall be construed to include the plurality of unless expressly stated otherwise.

In interpreting a component, it is interpreted to include an error range even if there is no separate description.

In the case of a description of a positional relationship, for example, when the positional relationship of two parts is described as "on," 2% "above," "over," "below," "under," "beside," "beneath," "near," 2% "close to," "adjacent to," "on a side of," "next" and the like, one or more other parts may be located between the two parts unless 'immediately' or 'directly' is used.

Spatially relative terms, such as "under," "below," "beneath," "lower," "over," "upper" and the like, may be used herein for ease of description to describe one element or feature's relationship to another element(s) or feature(s) as illustrated in the figures. It will be understood that the spatially relative terms can encompass different orientations of an element in use or operation in addition to the orientation depicted in the figures. For example, if an element in the figures is inverted, elements described as "below" or "beneath" other elements or features would then be oriented "over" the other elements or features. Thus, the exemplary term "below" can encompass both an orientation of below and above. Similarly, the exemplary term "above" or "over" can encompass both an orientation of "above" and "below."

In the description for the exemplary embodiments, the first, second, etc., are used to describe various components, but these components are not limited by these terms. These terms are only used to distinguish one component from another. Therefore, the first component mentioned below may be a second component within the technical spirit of the present disclosure.

Throughout the specification, the same reference numerals refer to the same component.

The features of each of the various exemplary embodiments may be combined or combined with each another, in whole or in part, and various technical interlocking and driving may be possible, and each of the exemplary embodiments may be implemented independently of each other or in conjunction with each other.

The word "exemplary" is used to mean serving as an example or illustration. Aspects are example aspects. "Embodiments," 2% "examples," "aspects," and the like should not be construed as preferred or advantageous over other implementations. An embodiment, an example, an exemplary embodiment, an aspect, or the like may refer to one or more embodiments, one or more examples, one or more example embodiments, one or more aspects, or the like, unless stated otherwise. Further, the term "may" encompasses all the meanings of the term "can."

As used herein, the term "connected" is intended to have the broadest possible meaning. Specifically, the phrase "A is connected to B" encompasses both a direct connection-where no intervening components or elements are present-and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The term "coupled" and "in contact" should be interpreted in the same manner.

The term "at least one" should be understood as including all possible combinations which can be suggested from one or more relevant items. For example, the meaning of "at least one of a first item, a second item, or a third item" may be each one of the first item, the second item, or the third item and also be all possible combinations that can be suggested from two or more of the first item, the second item, and the third item.

A term "device" used herein may refer to a display device including a display panel and a driver for driving the display panel. Examples of the display device may include a light emitting element, and the like. In addition, examples of the device may include a notebook computer, a television, a computer monitor, an automotive device, a wearable device, and an automotive equipment device, and a set electronic device (or apparatus) or a set device (or apparatus), for example, a mobile electronic device such as a smartphone or an electronic pad, which are complete products or final products respectively including light emitting element and the like, but embodiments of the present disclosure are not limited thereto.

In the specification, in adding reference numerals for elements in each drawing, it should be noted that like reference numerals already used to denote like elements in other drawings are used for elements wherever possible. In addition, the dimension scales of constituent elements shown in the drawings may be different from actual dimension scales, for convenience of description. That is, the dimension scales of constituent elements shown in the drawings should not be interpreted to be the same as those shown in the drawings.

In the recent information society, display devices have become increasingly important as visual information transmission media, and they are being improved to meet requirements such as low power consumption, thinness, weight reduction, high definition, and high efficiency.

The display device according to an exemplary embodiment of the present disclosure may reduce heat generation in a bottleneck where multiple wires are densely packed by utilizing a structurally improved display panel. For example, the display device may reduce heat generation due to concentration of wires by placing a plate-shaped metal layer under a plurality of wires to disperse heat generated from the plurality of wires. Additionally, the display device may use alignment marks to relieve spatial constraints in the bottleneck with densely packed wires, thereby reducing heat generation due to the densely packed wires. In addition, the display device may include a heat dissipation region exposed to the outside in the electrode pattern connected to the wires. Consequently, heat generated in the wires may be conducted to the electrode pattern and dissipated through the heat dissipation region, thereby preventing the temperature in the wires from rising above a preset temperature.

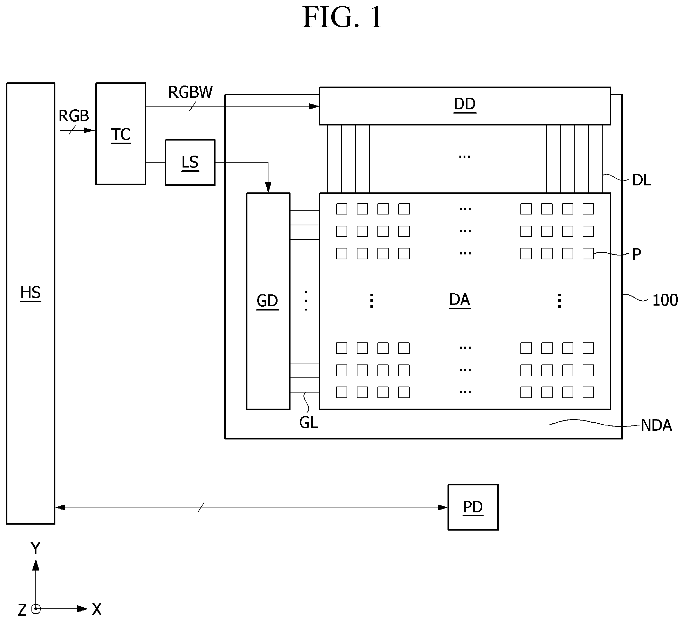

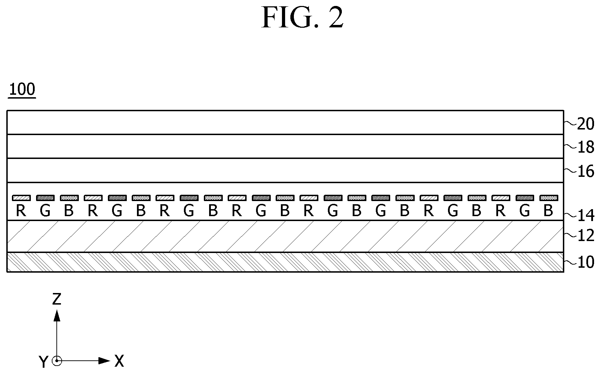

FIG. 1 is a diagram illustrating a display device according to one exemplary embodiment of the present disclosure. For example, FIG. 1 may be a plan view illustrating a display device according to one exemplary embodiment of the present disclosure. FIG. 2 is a cross-sectional view schematically illustrating a display panel according to one exemplary embodiment of the present disclosure.

Referring to FIGS. 1 and 2, a display device according to one exemplary embodiment of the present disclosure may include a display panel 100. The display device may further include an optical device (not shown) and a case (not shown) that protects the display panel and the optical device. Here, the optical device may be, but is not necessarily limited to, an illuminance sensor that senses how much light is reaching per unit area. For example, the optical device may include an image sensor (or camera), a proximity sensor, a white light illumination element, and an optical element for facial recognition. For example, the optical device may further include at least one of an image sensor, a proximity sensor, a gesture sensor, a motion sensor, a fingerprint sensor, and a biometric sensor.

The display panel 100 may implement the display of information, video, and/or images provided for the user. For example, the display panel 100 may include a substrate 10, and may further include a display area DA implementing information, videos, and/or images, and a non-display area NDA surrounding the display area DA.

The display area DA may be an area where an image is displayed. The display area DA may include a plurality of pixels P. Each of a plurality of pixels P may be composed of a plurality of sub-pixels.

Each of a plurality of pixels P may be composed of a red (R) sub-pixel, a green (G) sub-pixel, and a blue (B) sub-pixel, or composed of a red (R) sub-pixel, a green (G) sub-pixel, a blue (B) sub-pixel, and a white (W) sub-pixel. However, the present disclosure is not limited thereto. A plurality of subpixels SP constituting unit pixel may be variously modified in colors and configurations, as necessary.

For example, each of the plurality of subpixels SP may emit light having different wavelengths from each other. For example, the plurality of subpixels SP may include red, green, and blue subpixels, in which the red, green, and blue subpixels may be disposed in a repeated manner. Alternatively, the plurality of subpixels SP may include red, green, blue, and white subpixels, in which the red, green, blue, and white subpixels may be disposed in a repeated manner, or the red, green, blue, and white subpixels may be disposed in a quad type. For example, the red sub pixel, the blue sub pixel, and the green sub pixel may be sequentially disposed along a row direction, or the red sub pixel, the blue sub pixel, the green sub pixel and the white sub pixel may be sequentially disposed along the row direction. However, in the embodiment of the present disclosure, the color type, disposition type, and disposition order of the subpixels are not limiting, and may be configured in various forms according to light-emitting characteristics, device lifespans, and device specifications.

Meanwhile, the subpixels may have different light-emitting areas according to light-emitting characteristics. For example, a subpixel that emits light of a color different from that of a blue subpixel may have a different light-emitting area from that of the blue subpixel. For example, the red subpixel, the blue subpixel, and the green subpixel, or the red subpixel, the blue subpixel, the white subpixel, and the green subpixel may each has a different light-emitting area.

A plurality of light-emitting elements may be arranged in each of the plurality of sub-pixels. The plurality of light-emitting elements may be configured differently depending on the type of display device. For example, in the case where the display device is an inorganic light-emitting display device, the light-emitting elements may be light-emitting diodes (LED), micro light-emitting diodes (micro LED), or mini light-emitting diodes (mini LED), but exemplary embodiments of the present disclosure are not limited thereto. For example, in the case where the display device is an organic light-emitting display device, the light-emitting element may be an organic light emitting diode (OLED).

The non-display area NDA may be an area where no image is displayed and may be defined in an edge portion of the display panel to surround a portion or the entirety of the display area DA. The non-display area NDA may be an area adjacent to the display area DA. Further, the non-display area NDA may be an area disposed adjacent to the display area DA and configured to surround the display area DA. However, the present disclosure is not limited thereto.

For example, the non-display area NDA may include a first non-display area located outside the display area DA in a first direction, a second non-display area located outside the display area DA in a second direction intersecting the first direction, a third non-display area located outside the display area DA in the opposite direction to the first direction, and a fourth non-display area located outside the display area DA in the direction opposite to the second direction.

For another example, a boundary area between the display area DA and the non-display area NDA may be bent so that the non-display area NDA may be located below the display area. In this case, when the user looks at the display device from the front, there may be little or no non-display area NDA visible to the user. Various wires and circuits for driving a plurality of light-emitting elements P in the display area DA may be arranged in the non-display area NDA. For example, in the non-display area NDA, various wires and driving circuits may be mounted and a pad part may be arranged to which integrated circuits and printed circuits are connected, but exemplary embodiments of the present disclosure are not limited thereto.

The driving circuits may be a data driving circuit and/or a gate driving circuit, but exemplary embodiments of the present disclosure are not limited thereto. Wires to which control signals for controlling the driving circuits are supplied may be arranged on the display panel 100. For example, the control signals may include various timing signals including clock signals, input data enable signals, and synchronization signals, for example, the synchronization signals may include a vertical synchronization signal Vsync, a horizontal synchronization signal Hsync, but exemplary embodiments of the present disclosure are not limited thereto. Here, the horizontal synchronization signal is a signal representing a time taken to display one horizontal line of a screen and the vertical synchronization signal is a signal representing a time taken to display a screen of one frame. The data enable signal may correspond to a signal indicating a period for which a data voltage is supplied to the pixel. In this case, the control signal may be received via the pad part. For example, link wires LL for transmitting signals may be arranged in the non-display area NDA. For example, driving components such as flexible circuit boards and printed circuit boards may be connected to the pad part.

According to the present disclosure, the non-display area NDA may include a bending area. Here, the bending area may be any bendable area. The remaining area of the substrate 10 except for the bending area BA may be in a flat state. In addition, the pads may be disposed in the non-display area NDA.

The display panel 100 may have a width in the X-axis direction, a length in the Y-axis direction, and a thickness in the Z-axis direction. The width and length of the display panel 100 may be set to different design values depending on the area of application of the display device. Here, the X-axis direction may mean a width direction or a horizontal direction, the Y-axis direction may mean a longitudinal direction or a vertical direction, and the Z-axis direction may mean an up-down direction, a stacking direction, or a thickness direction. The X-axis direction, Y-axis direction, and Z-axis direction may be perpendicular to each other, but they may also mean different directions that are not perpendicular to each other. Each of the X-axis direction, Y-axis direction, and Z-axis direction may be described as one of a first direction, a second direction, and a third direction. In addition, the plane extending in the X-axis direction and the Y-axis direction may mean a horizontal plane.

The display panel 100 may include a circuit layer 12, a light-emitting element layer 14, and an encapsulation layer 16 disposed on the light-emitting element layer 14.

The display panel 100 may further include, but is not necessarily limited to, a touch sensor layer 18 and a color filter layer 20 disposed on the encapsulation layer 16. For example, depending on the intended use of the display device, at least one of the touch sensor layer 18 and the color filter layer 20 may be deleted.

The substrate 10 may be formed of an insulating material or a material with flexibility. For example, the substrate 10 may be formed of glass, metal, or plastic, but is not limited thereto. For example, the substrate may include a flexible polymer film. For example, the flexible polymer film may be made of any one of polyimide (PI), polyethylene terephthalate (PET), acrylonitrile-butadiene-styrene copolymer (ABS), polymethyl methacrylate (PMMA), polyethylene naphthalate (PEN), polycarbonate (PC), polyethersulfone (PES), polyarylate (PAR), polysulfone (PSF), cyclic olefin copolymer (COC), triacetylcellulose (TAC), polyvinyl alcohol (PVA), and polystyrene (PS). For example, the substrate may include a transparent polyimide material, and the present disclosure is not limited thereto.

The substrate 10 may include the display area DA and the non-display area NDA. The term of the display area DA and the non-display area NDA may not be limited to the substrate 10, but may be applied throughout the display device.

The circuit layer 12 may include a pixel circuit connected to wirings such as data lines, gate lines, and power lines, a gate driver connected to the gate lines, and the like. Further, the circuit layer 12 may include transistors implemented with thin film transistors (TFTs) and circuit elements such as capacitors or the like. Here, the wirings and circuit elements of the circuit layer 12 may be implemented with a plurality of insulating layers, two or more metal layers separated with the insulating layer interposed therebetween, and an active layer including a semiconductor material.

For example, the active layer may be formed of a semiconductor material such as an oxide semiconductor, amorphous silicon, or polysilicon, but is not limited thereto.

The oxide semiconductor material may have an excellent effect of preventing a leakage current and relatively inexpensive manufacturing cost. The oxide semiconductor may be made of a metal oxide such as zinc (Zn), indium (In), gallium (Ga), tin (Sn), and titanium (Ti) or a combination of a metal such as zinc (Zn), indium (In), gallium (Ga), tin (Sn), or titanium (Ti) and its oxide. Specifically, the oxide semiconductor may include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO), indium zinc oxide (IZO), indium gallium tin oxide (IGTO), and indium gallium oxide (IGO), but is not limited thereto.

The polycrystalline semiconductor material has a fast movement speed of carriers such as electrons and holes and thus has high mobility, and has low energy power consumption and superior reliability. The polycrystalline semiconductor may be made of polycrystalline silicon (poly-Si), but is not limited thereto.

The amorphous semiconductor material may be made of amorphous silicon (a-Si), but is not limited thereto.

The light emitting element layer 14 may include a light emitting element driven by a pixel circuit. Here, the light emitting element may be implemented with an organic light emitting diode (OLED). The OLED may include an organic compound layer formed between an anode and a cathode. The organic compound layer includes a hole injection layer (HIL), a hole transport layer (HTL), an emission layer (EML), an electron transport layer (ETL), and an electron injection layer (EIL), but is not limited thereto. When a voltage is applied to an anode and an cathode of the OLED, the holes passing through the hole transport layer (HTL) and the electrons passing through the electron transport layer (ETL) may be moved to the light emitting layer (EML) to form excitons and emit visible light from the light emitting layer (EML).

The light emitting element layer 14 may further include a color filter array disposed on the pixels to selectively transmit red, green, and blue wavelengths.

The light emitting element layer 14 may be covered by a protective film, and the protective film may be covered by an encapsulation layer 16. Here, the protective film may have a structure in which organic films and inorganic films are alternately stacked. In this case, the inorganic film may block penetration of moisture or oxygen. In addition, the organic film may planarize the surface of the inorganic film. When the organic film and the inorganic film are stacked in multiple layers, a movement path of moisture or oxygen is longer than that of a single layer, so that the penetration of moisture/oxygen affecting the light emitting element layer 14 may be effectively blocked.

The encapsulation layer 16 covers the light-emitting element layer 14 so as to seal the circuit layer 12 and the light-emitting element layer 14. Here, the encapsulation layer 16 may have a multi-insulation layer structure in which organic layers and inorganic films are alternately stacked. In this case, the inorganic film blocks penetration of moisture or oxygen. The organic layer flattens the surface of the inorganic film. When the organic layer and the inorganic film are stacked in multiple layers, the movement path of moisture or oxygen is longer than that of a single layer, so that penetration of moisture/oxygen affecting the light-emitting element layer 14 may be effectively blocked.

For example, the encapsulation layer may include a first inorganic encapsulation layer, a first organic encapsulation layer, and a second inorganic encapsulation layer, Alternatively, the encapsulation layer may include a first inorganic encapsulation layer, a first organic encapsulation layer, a second inorganic encapsulation layer, a second organic encapsulation layer, and a third inorganic encapsulation layer stacked sequentially.

The first inorganic encapsulation layer, the second inorganic encapsulation layer, and the third inorganic encapsulation layer may serve to block the penetration of moisture or oxygen. The first inorganic encapsulation layer, the second inorganic encapsulation layer, and the third inorganic encapsulation layer may be made of an inorganic material, for example, an inorganic material such as silicon nitride (SiNx), silicon oxide (SiOx), or aluminum oxide (AlOx). However, the present disclosure is not limited thereto.

The first organic encapsulation layer is disposed between the first inorganic encapsulation layer and the second inorganic encapsulation layer, and the second organic encapsulation layer is disposed between the second inorganic encapsulation layer and the third inorganic encapsulation layer. The first organic encapsulation layer and the second organic encapsulation layer may each have a larger thickness than each of the first inorganic encapsulation layer, the second inorganic encapsulation layer, and the third inorganic encapsulation layer in order to adsorb or block particles that may be produced during a process of manufacturing the display device. The first organic encapsulation layer and the second organic encapsulation layer may fill cracks that may be formed in the first inorganic encapsulation layer and the second inorganic encapsulation layer. The first organic encapsulation layer and the second organic encapsulation layer may planarize an upper portion of the first inorganic encapsulation layer and an upper portion of the second inorganic encapsulation layer by covering particles on the first inorganic encapsulation layer and the second inorganic encapsulation layer respectively. For example, the first organic encapsulation layer may planarize an upper portion of the first inorganic encapsulation layer by covering particles on the first inorganic encapsulation layer. For example, the second organic encapsulation layer may planarize an upper portion of the second inorganic encapsulation layer by covering particles on the second inorganic encapsulation layer. The first organic encapsulation layer and the second organic encapsulation layer may be made of an organic material, and for example, epoxy polymer, acrylic polymer, or the like may be used. However, the present disclosure is not limited thereto.

Meanwhile, the encapsulation layer is not limited to three or five layers, for example, n layers alternately stacked between inorganic encapsulation layer and organic encapsulation layer (where n is an integer greater than 3) may be included.

The touch sensor layer 18 may include capacitive touch sensors that sense a touch input based on a change in capacitance before and after touch input. The touch sensor layer 18 may include metal line patterns and insulating films that constitute the capacitance of the touch sensors. The insulating films may insulate the intersections of the metal line patterns and planarize the surface of the touch sensor layer.

A color filter layer 20 may be formed on the touch sensor layer 18. The color filter layer 20 may include red, green, and blue color filters. In addition, the color filter layer 20 may further include a black matrix pattern. The color filter layer 20 may absorb some wavelengths of light reflected from the circuit layer 12 to serve as a polarizing plate and increase color purity.

The color filter layer 20 may include an organic film covering the color filter and the black matrix pattern. An extended portion of the organic film may cover the remaining inorganic film or the substrate 10 in the bezel area, that is, an edge area of the display panel 100.

The display device according to an exemplary embodiment of the present disclosure may include a display panel 100 having a pixel array arranged on the screen, a display panel driver, or the like.

The pixel array of the display panel 100 may include data lines DL, gate lines GL intersecting the data lines DL, and pixels P connected to the data lines DL and the gate lines GL and arranged in a matrix form.

The pixel array may be divided into a circuit layer 12 and a light-emitting element layer 14 as shown in FIG. 2. In addition, a touch sensor array may be arranged on the light-emitting element layer 14. Here, each of the pixels of the pixel array may include, but not necessarily limited to, two to four sub-pixels. Each of the sub-pixels may include a pixel circuit arranged on the circuit layer 12.

The sub-pixels of the display area DA may include pixel circuits. The pixel circuit may include a driving element that supplies a current to the light-emitting element (OLED), a plurality of switch elements that sample the threshold voltage of the driving element and switch the current path of the pixel circuit, and a capacitor that maintains the gate voltage of the driving element. Here, the pixel circuit may be arranged under the light-emitting element.

The display panel driver may write pixel data of the input image to the pixels P under the control of a controller TC. The pixels P may be interpreted as a pixel group including multiple sub-pixels. Here, the controller TC may be a timing controller.

The display panel driver may include a data driver DD that supplies data voltage of the pixel data to the data lines DL, and a gate driver GD that sequentially supplies gate pulses to the gate lines GL. Also, the data driver DD may be integrated into the drive IC. Additionally, the display panel driver may further include a touch sensor driver (not shown).

The drive IC may be attached on, but not limited to, the display panel 100. The drive IC receives pixel data of the input image and timing signals from the host system HS, supplies data voltage of the pixel data to the pixels, and synchronizes the data driver DD and the gate driver GD.

The drive IC may be connected to the data lines DL through the data output channels and supply the data voltage of the pixel data to the data lines DL. The drive IC may output gate timing signals for controlling the gate driver GD through gate timing signal output channels.

The gate driver GD may be formed together with the pixel array in the circuit layer of the display panel 100.

The gate driver GD may be arranged on the non-display area NA of the display panel 100, or at least a part thereof may be arranged within the display area DA where the input image is reproduced.

The gate driver GD may be arranged on one side of the left and right non-display areas NA of the display panel 100 and supply gate signals to the gate lines GL in a single feeding manner, without being limited thereto. For example, the gate driver GD may be arranged in the non-display areas NA on both sides of the display panel 100 with the display area DA of the display panel 100 interposed therebetween, and may supply gate pulses on both sides of the gate lines GL in a double feeding manner. The gate driver GD may output pulses of gate signals (hereinafter, "gate pulses") in sequence to the gate lines under the control of the controller TC. The gate driver GD may shift the gate pulses by using a shift register to sequentially supply the resulting signals to the gate lines GL. The gate driver GD may include, but not limited to, one or more shift registers that output pulses of gate signals. The gate signals may include scan pulses and EM pulses of the emission signal.

The controller TC may start scanning according to the timing implemented in each frame, convert the input image data input from the outside into the data signal format used by the data driver DD, supply the converted image data Data to the data driver DD, and control the data driving at an appropriate time according to the scanning. For example, to control the data driver DD, the controller TC may output various data control signals (DCS) including a source start pulse (SSP), a source sampling clock (SSC), a source output enable (SOE) signal, or the like. For example, to control the gate driver GD, the controller TC may output various gate control signals (GCS) including a gate start pulse (GSP), a gate shift clock (GSC), a gate output enable (GOE) signal, or the like.

The controller TC may convert the three primary color pixel data RGB input from the host system HS into four color sub-color data RGBW by adding white data and transfer the same to the data driver DD.

The controller TC may be configured to be coupled with various processors, for example, a microprocessor, a mobile processor, an application processor, etc., in accordance with a device mounted therein.

The controller TC may be implemented in a separate component from the data driver DD, or integrated with the data driver DD, so that the controller TC and the data driver DD can be implemented in a single integrated circuit.

The controller TC may be a timing controller used in the typical display technology or a control apparatus/device capable of additionally performing other control functionalities in addition to the typical function of the timing controller. In one or more embodiments, the controller TC may be one or more other control circuits different from the timing controller, or a circuit or component in the control apparatus/device. The controller TC may be implemented using various circuits or electronic components such as an integrated circuit (IC), a field programmable gate array (FPGA), an application specific integrated circuit (ASIC), a processor, and/or the like.

The controller TC may be mounted on a printed circuit board, a flexible printed circuit, or the like, and may be electrically connected to the data driver DD and the gate driver GD through the printed circuit board, the flexible printed circuit, and/or the like.

The controller TC can transmit signals to, and receive signals from, the data driver DD via one or more predetermined interfaces. For example, such interfaces may include a low voltage differential signaling (LVDS) interface, an embedded clock point-point interface (EPI), a serial peripheral interface (SPI), and the like. However, the present disclosure is not limited thereto.

The power supply PD may output the voltage required for driving the pixels of the display panel 100 and the display panel driver by using a DC-DC converter or the like. Here, the DC-DC converter may include a charge pump, a regulator, a buck converter, a boost converter, or the like.

The level shifter LS may receive a gate timing control signal from the controller TC and generate a start pulse and a shift clock to supply them to the gate driver GD. The start pulse and shift clock output from the level shifter LS may swing between the gate high voltage and the gate low voltage.

The host system HS may be implemented with an application processor (AP). The host system HS may transfer pixel data of the input image to the drive IC. The host system HS may be connected to the drive IC through, for example, a flexible printed circuit (FPC).

Meanwhile, the display panel 100 may be implemented with a flexible panel applicable to a flexible display.

The flexible panel may be manufactured as a so-called "plastic OLED panel." The plastic OLED panel may include a back plate, an organic thin film adhered to the back plate, and a pixel array on the organic thin film. A touch sensor array may be formed on the pixel array.

The back plate may be a PET (polyethylene terephthalate) substrate. The back plate may block moisture permeation toward the organic thin film to prevent the pixel array from being exposed to humidity.

The organic thin film may be a PI (polyimide) substrate. A multilayer buffer film may be formed with an insulating material (not shown) on the organic thin film. Additionally, the circuit layer 12 and the light-emitting element layer 14 may be stacked on the organic thin film.

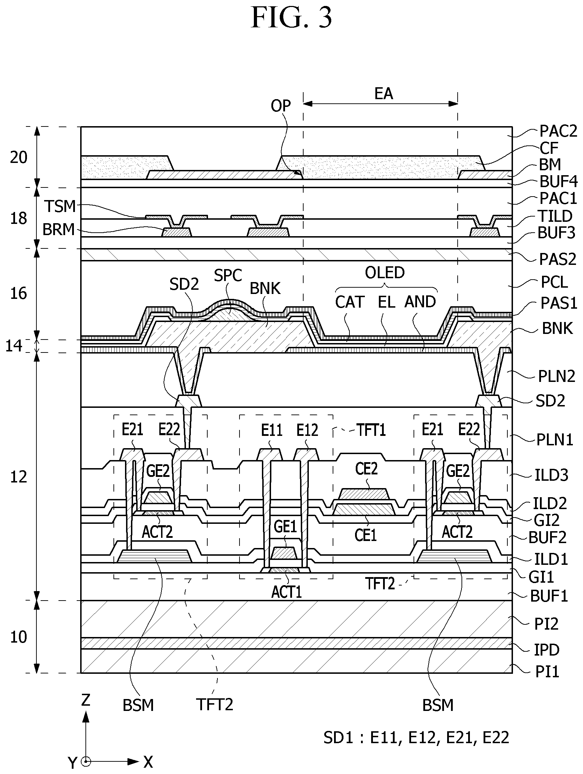

FIG. 3 is a cross-sectional view showing a cross-sectional structure of the pixel area arranged in the display area of the display panel according to an exemplary embodiment of the present disclosure. Here, it should be noted that the cross-sectional structure of the pixel area is not limited to FIG. 3. In FIG. 3, "TFT" may indicate the driving element of the pixel circuit. Specifically, reference symbol TFT1 may indicate a first TFT, which is one of the LTPS TFTs arranged in the display area, and reference symbol TFT2 may indicate a second TFT, which is one of the oxide TFTs arranged in the display area.

Referring to FIG. 3, a plurality of pixel circuits and wires connected to the pixel circuits may be arranged in the display area DA of the display panel 100. Here, the pixel circuits of the display area may include a pixel circuit of a red sub-pixel that drives a red light-emitting element, a pixel circuit of a green sub-pixel that drives a green light-emitting element, and a pixel circuit of a blue sub-pixel that drives a blue light-emitting element. In addition, the pixel circuits may be separated into a plurality of circuit regions along the X-axis direction of the display panel 100 within the display area DA.

The substrate 10 may include a first substrate PI1 and a second substrate PI2. Further, an inorganic film IPD may be formed between the first substrate PI1 and the second substrate PI2. Here, the inorganic film IPD may block moisture penetration. In this case, as the substrate 10 may be made of polyimide, it may be called a PI substrate, and the first and second substrates PI1 and PI2 may be called first and second PI substrates.

In the display device according to an exemplary embodiment of the present disclosure, the substrate 10 may be, but not limited to, a PI substrate. For example, the substrate 10 may be a glass substrate including a glass material.

A first buffer layer BUF1 may be formed on the second substrate PI2. The first buffer layer BUF1 may be formed as a multilayer insulating film in which two or more oxide films (SiO₂) and nitride films (SiNx) are stacked. For example, the first buffer layer BUF1 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the exemplary embodiments of the present disclosure are not limited thereto. The first buffer layer BUF1 may be excluded in accordance with the structure or properties of the display device. A first semiconductor layer is formed on the first buffer layer BUF1. The first semiconductor layer may include a polysilicon semiconductor layer patterned in a photolithography process. The first semiconductor layer may include a polysilicon active pattern ACT1 forming a semiconductor channel in the first TFT TFT1.

A first gate insulating layer GI1 is deposited on the first buffer layer BUF1 to cover the active pattern ACT1 of the first semiconductor layer. The first gate insulating layer GI1 includes an inorganic insulating material layer. For example, the first gate insulating layer GI1 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the exemplary embodiments of the present disclosure are not limited thereto. A first metal layer is formed on the first gate insulating layer GI1. The first metal layer is insulated from the first semiconductor layer by the first gate insulating layer GI1.

The first metal layer may include a single-layer metal or stacked metal patterns with two or more metal layers, patterned through a photolithography process. The first metal layer may include a gate electrode GE1 of the first TFT TFT1 and a light shield pattern BSM under the second TFT TFT2.

A first interlayer insulating layer ILD1 is formed on the first gate insulating layer GI1 to cover the patterns of the first metal layer. The first interlayer insulating layer ILD1 may include an inorganic insulating material. For example, the first interlayer insulating layer ILD1 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the exemplary embodiments of the present disclosure are not limited thereto. A second buffer layer BUF2 is formed on the first interlayer insulating layer ILD1. The second buffer layer BUF2 may include a single layer or multi-layer inorganic insulating material. For example, the second buffer layer BUF2 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the exemplary embodiments of the present disclosure are not limited thereto.

The second semiconductor layer may include an oxide semiconductor pattern ACT2 forming a semiconductor channel in the second TFT TFT2. The second gate insulating layer GI2 may be deposited on the second buffer layer BUF2 to cover the active pattern ACT2 of the second semiconductor layer. The second gate insulating layer GI2 may include a single-layer or multi-layer inorganic insulating material. For example, the second gate insulating layer GI2 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the exemplary embodiments of the present disclosure are not limited thereto. A second metal layer may be formed on the second gate insulating layer GI2. The second metal layer may be insulated from the second semiconductor layer by the second gate insulating layer GI2.

The second metal layer may include a single-layer metal or stacked metal patterns with two or more metal layers, patterned through a photolithography process. The second metal layer may include a gate electrode GE2 of the second TFT TFT2 and a lower capacitor electrode CE1.

A second interlayer insulating layer ILD2 may be formed on the second gate insulating layer GI2 to cover the patterns of the second metal layer. The second interlayer insulating layer ILD2 may include a single-layer or multi-layer inorganic insulating material. For example, the second interlayer insulating layer ILD2 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the exemplary embodiments of the present disclosure are not limited thereto. A third metal layer may be formed on the second interlayer insulating layer ILD2. The third metal layer may be insulated from the second metal layer by the second interlayer insulating layer ILD2.

The third metal layer may include a single-layer metal or stacked metal patterns with two or more metal layers, patterned through a photolithography process. The third metal layer may include an upper capacitor electrode CE2. The capacitor Cst of the pixel circuit may be composed of an upper capacitor electrode CE2, a lower capacitor electrode CE1, and a dielectric layer between the upper capacitor electrode CE2 and the lower capacitor electrode CE1, *i.e.*, the second interlayer insulating layer ILD2.

A third interlayer insulating layer ILD3 covering the patterns of the third metal layer may be formed on the second interlayer insulating layer ILD2. The third interlayer insulating layer ILD3 may include a single-layer or multi-layer inorganic insulating material. For example, the third interlayer insulating layer ILD3 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the exemplary embodiments of the present disclosure are not limited thereto. A fourth metal layer may be formed on the third interlayer insulating layer ILD3. The fourth metal layer may be insulated from the second semiconductor layer by the second gate insulating layer GI2.

The fourth metal layer SD1 may include a single-layer metal or stacked metal patterns with two or more metal layers, patterned through a photolithography process. The fourth metal layer SD1 may include first and second electrodes E11 and E12 of the first TFT TFT1, and first and second electrodes E21 and E22 of the second TFT TFT2. The first and second electrodes E11 and E12 of the first TFT TFT1 may be connected to the first active pattern ACT1 through a first contact hole penetrating the insulating layers GI1, ILD1, BUF2, GI2, ILD2 and ILD3. The first and second electrodes E21 and E22 of the second TFT TFT2 may be connected to the second active pattern ACT2 through a second contact hole penetrating the insulating layers GI2, ILD2 and ILD3. The first electrode E21 of the second TFT TFT2 may be connected to the light shield pattern BSM through a third contact hole penetrating the insulating layers ILD1, BUF2, GI2, ILD2 and ILD3. Here, a high-strength electric field may be generated in the metal patterns E11 to E22 of the fourth metal layer SD1 due to voltages having a large voltage difference and swinging between the gate-on voltage and the gate-off voltage.

The first planarization layer PLN1 may cover the patterns E11 to E22 of the fourth metal layer SD1. The first planarization layer PLN1 may thickly cover the display area DA of the circuit layer 12 with an organic insulating material. For example, the organic insulating material may include acrylic resin or photosensitive polyimide, but not limited thereto. When the first planarization layer PLN is applied on the circuit layer 12, the organic insulating material may flow to the edge of the display panel 100 to cover the side surface of the circuit layer 12.

A fifth metal layer may be formed on the first planarization layer PLN1. The fifth metal layer may be insulated from the fourth metal layer SD1 by the first planarization layer PLN1. The fifth metal layer may include a single-layer metal or stacked metal patterns with two or more metal layers, patterned through a photolithography process. The fifth metal layer may include a metal pattern SD2 that connects the light-emitting element to the second TFT TFT2. The metal pattern SD2 may be connected to the second electrode E22 of the second TFT TFT2 through a fourth contact hole penetrating the first planarization layer PLN1.

A second planarization layer PLN2 may be formed on the first planarization layer PLN1 to cover the metal patterns of the fifth metal layer. The second planarization layer PLN2 may thickly cover the display area DA of the circuit layer 12 with an organic insulating material. For example, the organic insulating material may include acrylic resin or photosensitive polyimide, but not limited thereto. A sixth metal layer may be formed on the second planarization layer PLN2. The second planarization layer PLN2 may planarize the surface on which a sixth metal layer is formed.

The sixth metal layer may include a single-layer metal or stacked metal patterns with two or more metal layers, patterned through a photolithography process. The pattern of the sixth metal layer may include an anode electrode AND of the light-emitting element. The anode electrode AND may be brought into contact with the metal pattern SD2 connected to the second TFTs TFT2 of the pixel circuits through a fifth contact hole penetrating the second planarization layer PLN2.

In the light-emitting element layer 14, a bank BNK may be formed on the second planarization layer PLN2 to cover the edge of the anode electrode AND. Here, the bank BNK may be formed in a pattern to distinguish the emission area (or, aperture area) from which light is emitted to the outside from each pixel. Hence, the bank BNK may be called a pixel defining layer.

According to the present disclosure, the bank BNK may be disposed in each of the plurality of sub-pixels. The bank BNK may be formed of an opaque material (for example, black) in order to prevent light interference between adjacent pixels. In this case, the bank BNK may include a light shielding material constituted by at least one of a color pigment, organic black, or carbon, without being limited thereto.

For example, the bank BNK may include an inorganic insulating material, such as silicon nitride (SiNx) or silicon oxide (SiOx), or the bank BNK may be formed of black resin. Meanwhile, the bank BNK can be formed of an organic layer such as an acryl-based material, an epoxy-based material, a phenolic-based material, a polyamide-based material, or a polyimide-based material. However, the present disclosure is not limited thereto.

For example, the bank BNK may be patterned in a photolithography process by including an organic insulating material having photosensitivity. Further, a spacer SPC with a preset height may be formed on the bank BNK. Here, the bank BNK and the spacer SPC may be integrated with the same organic insulating material. Additionally, the spacer SPC may secure a gap between the fine metal mask (FMM) and the anode electrode AND to prevent the FMM from coming into contact with the anode electrode AND in a deposition process of the light-emitting element made of an organic compound.

A seventh metal layer used as a cathode electrode CAT of the light-emitting element may be formed on the bank BNK and the organic compound layer EL. The seventh metal layer may form a connection between sub-pixels in the display area DA. Here, the organic compound layer EL may be called an emission layer or electroluminescence layer.

The encapsulation layer 16 may include a multi-insulating layer covering the cathode electrode CAT of the light-emitting element. The multi-insulating layer may include a first inorganic insulating layer PAS1 covering the cathode electrode CAT, a thick organic insulating layer PCL covering the first inorganic insulating layer PAS1, and a second inorganic insulating layer PAS2 covering the organic insulating layer PCL.

The touch sensor layer 18 may include a third buffer layer BUF3 covering the second inorganic insulating layer PAS2, a bridge metal BRM arranged on the third buffer layer BUF3, an inorganic touch interlayer insulating layer TILD covering the bridge metal BRM, a touch sensor metal TSM arranged on the bridge metal BRM, and a first organic insulating layer PAC1 covering the touch interlayer insulating layer TILD and the touch sensor metal TSM. Here, the third buffer layer BUF3 may be a touch buffer layer. Further, the first organic insulating layer PAC1 may include an organic insulating material.

The third buffer layer BUF3 may include a single-layer or multi-layer inorganic insulating material. For example, the third buffer layer BUF3 may be formed as a multi-layer insulating film in which two or more oxide films (SiO₂) and nitride films (SiNx) are stacked.

The eighth metal layer used as a bridge metal BRM may be arranged on the third buffer layer BUF3 and may overlap with the bank BNK. The eighth metal layer may include a single-layer metal or stacked metal patterns with two or more metal layers, patterned through a photolithography process.

The ninth metal layer may include a single-layer metal or stacked metal patterns with two or more metal layers, patterned through a photolithography process. The pattern of the ninth metal layer may include a touch sensor metal TSM. The touch sensor metal TSM may come into contact with the bridge metal BRM through a sixth contact hole penetrating the touch interlayer insulating layer TILD.

The color filter layer 20 may include a fourth buffer layer BUF4 covering the first organic insulating layer PAC1, a black matrix BM arranged on the fourth buffer layer BUF4 and including an opening OP, a color filter CF arranged in the opening OP of the black matrix BM, and a second organic insulating layer PAC2 covering the black matrix BM and the color filter. Here, the fourth buffer layer BUF4 may be a color filter buffer layer. Further, the second organic insulating layer PAC2 may include an organic insulating material and may be a color filter insulating layer.

The fourth buffer layer BUF4 may include a single-layer or multi-layer inorganic insulating material. For example, the fourth buffer layer BUF4 may be formed as a multi-layer insulating film in which two or more oxide films (SiO₂) and nitride films (SiNx) are stacked.

The black matrix BM may be made of a material with high optical density (OD). Hence, the black matrix BM may absorb or block light.

The black matrix BM may overlap with the touch sensor metal TSM and the bridge metal BRM. Hence, the black matrix BM may prevent external light from being reflected by the touch sensor metal TSM and the bridge metal BRM.

The color filter CF may be arranged in correspondence to the emission area EA of the light-emitting element OLED and may include one of red, green, and blue colors.

The color filter CF may include a red color filter, a green color filter, and a blue color filter to match the color of each sub-pixel. Hence, the color filter CF may be arranged in the opening OP of the black matrix BM. Additionally, the color filter CF may overlap with the emission area EA in the Z-axis direction.

The second organic insulating layer PAC2 may be arranged on the black matrix BM and the color filter CF. Additionally, the second organic insulating layer PAC2 may be made of an organic insulating material such as polyimide or acrylic resin.

A cover glass (not shown) may be arranged on the color filter layer 20.

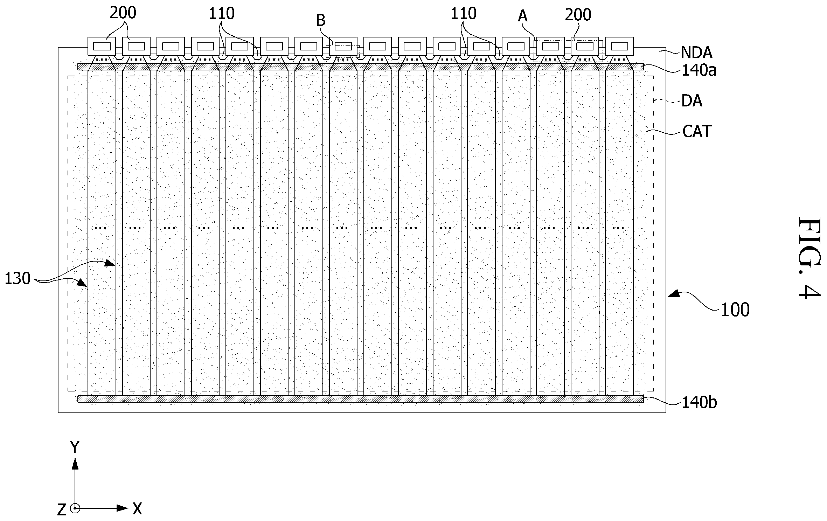

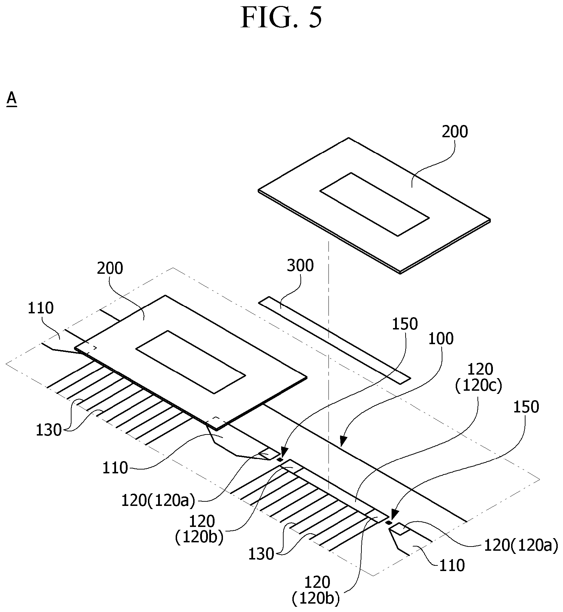

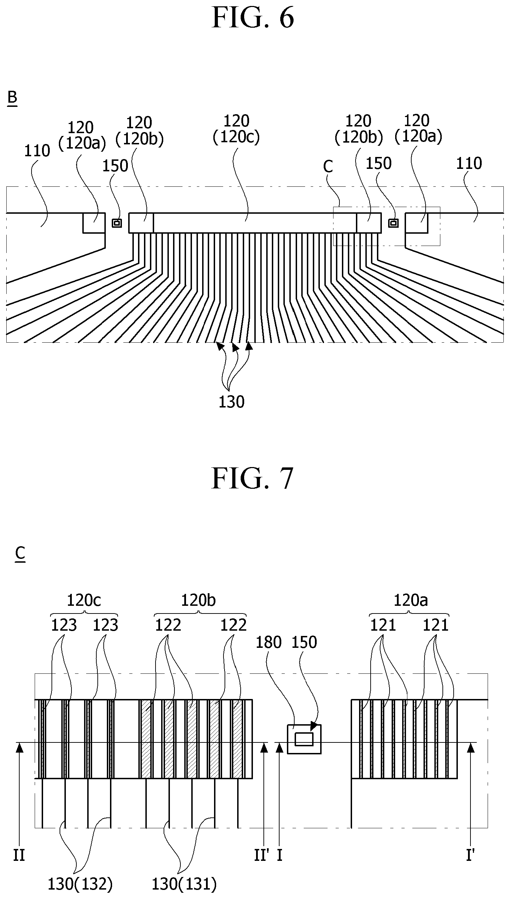

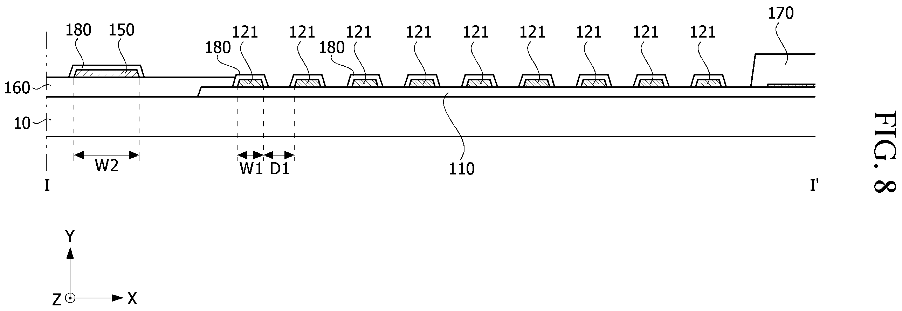

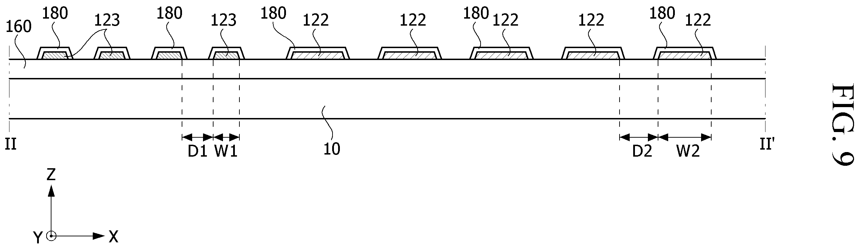

FIG. 4 is a view illustrating the arrangement relationship between the display panel and the circuit board according to an exemplary embodiment of the present disclosure. For example, FIG. 4 may be a top view showing a display panel and a plurality of circuit boards attached to the display panel according to an exemplary embodiment of the present disclosure. FIG. 5 is a view illustrating the arrangement relationship between the pad, circuit board, and adhesive member of the display panel with respect to region A of FIG. 4. FIG. 6 is an enlarged view showing the electrode pattern and pad arranged on the display panel with respect to region B of FIG. 4. For example, FIG. 6 may be an enlarged view showing the display panel from which the circuit board and adhesive member are excluded in region B of FIG. 4. FIG. 7 is an enlarged view showing region C of FIG. 6. FIG. 8 is a cross-sectional view taken along line I-I' of FIG. 7. For example, FIG. 8 may be a cross-sectional view showing the arrangement relationship between the electrode pattern, first pad, and alignment mark, which are arranged on the substrate. FIG. 9 is a cross-sectional view taken along line II-II' of FIG. 7. For example, FIG. 9 may be a cross-sectional view showing the arrangement relationship between the second pad and the third pad arranged on the substrate.

The display device according to an exemplary embodiment of the present disclosure may include a display panel 100, a plurality of circuit boards 200 arranged in the non-display area NDA of the display panel 100, and an adhesive member 300 that attaches the circuit boards 200 to the pad 120 of the display panel 100. Here, the circuit board 200 may be a flexible printed circuit board on which a drive IC is mounted. For example, the circuit board 200 may be a chip on film (COF).

The conductive adhesive member 300 may be arranged between the pad 120 of the display panel 100 and the circuit board 200 to thereby electrically connect the pad 120 of the display panel 100 and the circuit board 200. Consequently, the circuit board 200, the electrode pattern 110, the circuit board 200, and the wires 130 may be electrically connected. In this case, an anisotropic conductive film (ACF) may be provided as the adhesive member 300. Here, the anisotropic conductive film may be a thin film made of an adhesive resin component containing conductive particles to provide vertical electrical conductivity and adhesion. Also, the conductive particles may be a plurality of small metallic particles or a plurality of conductive balls for transmitting signals within the adhesive member 300. Since the anisotropic conductive film contains conductive particles that are arranged in a dispersed manner, it may perform the function of conducting electricity, and may maintain adhesive strength as the adhesive resin is cured by heat and pressure.

If the pad 120 is formed in a plate shape, the current density may be reduced, which may be advantageous for heat generation. However, when a pressure is applied to the anisotropic conductive film together with specific heat, a repulsive force due to adhesion of the anisotropic conductive film may be applied to the anisotropic conductive film owing to the pad 120 formed in a plate shape. Additionally, a defect in which the anisotropic conductive film is not bonded due to the repulsive force may occur. For example, a lifting phenomenon may occur in the anisotropic conductive film due to the repulsive force, and the lifting phenomenon may cause the conductive balls to gather in one place, thereby hindering the flow of current. For instance, since current flows only through the conductive balls gathered in one place, current may not flow through some part of the pad 120.

Hence, the pad 120 may be provided in a form of multiple wires arranged to be spaced apart from each other. Consequently, the pad 120 may secure a space in which a part of the anisotropic conductive film may be moved so as to alleviate the repulsive force applied to the anisotropic conductive film. Specifically, when heat and pressure are applied to the anisotropic conductive film, to provide a space through which a part of the anisotropic conductive film may escape, the pad 120 may be provided in the form of multiple wires arranged to be spaced apart from each other. For example, the first pad 120a, the second pad 120b, and the third pad 120c may be provided as, but not limited to, multiple wires arranged to be spaced apart from each other in the X-axis direction. For instance, since the first pad 120a may be electrically connected to the plate-shaped electrode pattern 110 other than the wires 130, the first pad 120a may be provided as multiple first pad wires 121 that are arranged to be spaced apart from each other in the Y-axis direction.

As the pad 120 is provided as multiple wires, a bottleneck with densely packed wires may be formed in the pad 120. For example, since the first pad 120a includes a plurality of first pad wires 121 that are densely arranged in a limited space due to the arrangement relationship with the electrode pattern 110, the plurality of first pad wires 121 may form a bottleneck. Hence, the temperature at the first pad 120a may be relatively higher than that at the other pads 120b and 120c.

Therefore, the display device according to an exemplary embodiment of the present disclosure may disperse the heat generated from the first pad 120a by arranging an electrode pattern 110 under the first pad 120a composed of a plurality of first pad wires 121. However, since the electrode pattern 110 made of metal is placed under the first pad 120a, it is difficult to check whether the circuit board 200 and the first pad 120a are normally attached through a test equipment arranged under the display panel 100. So, by forming a hole H overlapping some of the first pad wires 121 in the electrode pattern 110, it is possible to check whether the circuit board 200 and the first pad 120a are normally attached. For example, when pressure is applied to the anisotropic conductive film together with a specific amount of heat, an impression may appear on the first pad wires 121. Then, by checking this impression, it is possible to check whether the circuit board 200 and the first pad 120a are normally attached.

In addition, the display device according to an exemplary embodiment of the present disclosure may separate the first pad 120a from the second pad 120b through the arrangement of an alignment mark 150. Hence, the influence of heat generated from the second pad 120b on the first pad 120a may be reduced.

In addition, the display device according to an exemplary embodiment of the present disclosure may improve the dissipation of heat transferred from the first pad 120a to the electrode pattern 110 by forming a heat dissipation structure exposed to the outside on the electrode pattern 110.

That is, the display device according to an exemplary embodiment of the present disclosure may utilize at least one or a combination of the arrangement relationship between the first pad 120a and the electrode pattern 110, the arrangement position of the alignment mark 150, and the heat dissipation structure formed on the electrode pattern 110, to thereby prevent and/or minimize damage to the display panel 100 caused by heat generated from the first pad 120a.

The display panel 100 may include an electrode pattern 110 arranged on the substrate 10, a pad 120 overlapping with the circuit board 200, and a plurality of wires 130 connected to the circuit board 200 through the pad 120. Here, the pad 120 may include a first pad 120a and a second pad 120b that are arranged to be spaced apart from each other in the X-axis direction. Additionally, the pad 120 may include, but not limited to, a third pad 120c arranged between two second pads 120b. In this case, the wires 130 may be connected to the second pad 120b and the third pad 120c.

In addition, the display panel 100 may include a first bar 140a and a second bar 140b arranged with the display area DA interposed therebetween. The first bar 140a may be arranged closer to the circuit board 200 compared with the second bar 140b. Here, each of the first bar 140a and the second bar 140b may be formed in a bar shape and may be arranged in the non-display area NDA in the X-axis direction. For example, each of the first bar 140a and the second bar 140b may be arranged parallel to the display area DA of the display panel 100. Additionally, the first bar 140a and the second bar 140b may be electrically connected to the plurality of wires 130. Hence, when a voltage is applied to the wires 130 through the circuit board 200, the voltage may be effectively applied to those wires 130 that are not directly connected to the circuit board 200. Here, the voltage applied to the wires 130 may be, but not limited to, a driving voltage.

In addition, the display panel 100 may include an alignment mark 150 arranged between the first pad 120a and the second pad 120b with respect to the X-axis direction. As the alignment mark 150 may be arranged to overlap with the circuit board 200, it may guide the circuit board 200 to be placed at a preset position.

Referring to FIGS. 7 to 9, the display panel 100 may include: an electrode pattern 110 and an insulating layer 160 arranged on the substrate 10; a first pad 120a and an overcoat layer 170 arranged on the electrode pattern 110; a second pad 120b, a third pad 120c, and an alignment mark 150 arranged on the insulating layer 160; and a conductive encapsulation film 180 covering the first pad 120a, the second pad 120b, the third pad 120c, and the alignment mark 150.

The electrode pattern 110 may be positioned between the circuit boards 200 that are arranged adjacent to each other with respect to the X-axis direction.

A part of the electrode pattern 110 may overlap with the circuit board 200 in the Z-axis direction. For example, a part of the electrode pattern 110 may overlap the circuit board 200 in the Z-axis direction with the first pad 120a interposed therebetween. Thereby, the electrode pattern 110 may be electrically connected to the circuit board 200 by the medium of the first pad 120a.

As a part of the electrode pattern 110 and the circuit board 200 overlap in the Z-axis direction, one side of the electrode pattern 110 may be electrically connected to the circuit board 200 through the first pad 120a.

In addition, the other side of the electrode pattern 110 may be electrically connected to the cathode electrode CAT provided as a common electrode. As shown in FIG. 5, one side of the electrode pattern 110 may overlap with the cathode electrode CAT. Here, one side of the electrode pattern 110 and the cathode electrode CAT may be electrically connected through a contact hole. For example, an insulating layer or the like may be arranged between one side of the electrode pattern 110 and the cathode electrode CAT with respect to the Z-axis direction, and the electrode pattern 110 may come into contact with the cathode electrode CAT through the contact hole formed in the insulating layer or the like.

Hence, the common voltage applied through the circuit board 200 may be applied to the cathode electrode CAT through the first pad 120a and the electrode pattern 110. Here, the common voltage may be, but not limited to, a low-potential voltage.

The electrode pattern 110 may be made of a plate-shaped metal material. Hence, as the heat generated from the first pad 120a and transferred to one side of the electrode pattern 110 may be distributed to the entire electrode pattern 110, the plate-shaped electrode pattern 110 may improve the heat dissipation effect of the heat generated from the first pad 120a. For example, a bottleneck may be formed because the first pad 120a is provided as a plurality of first pad wires 121 arranged to be spaced apart from each other. Here, the electrode pattern 110 may be arranged to overlap with the first pad 120a in the X-axis direction and the Y-axis direction. Consequently, the heat generated from the plurality of first pad wires 121 may be distributed in the X-axis direction and the Y-axis direction through the electrode pattern 110. Here, the X-axis direction may be a first direction, and the Y-axis direction may be a second direction. Here, the direction in which the electrode pattern 110 and the first pad 120a overlap may be a third direction, and the third direction may be the Z-axis direction.

The electrode pattern 110 may be formed together with the light shield pattern BSM during the same mask process that forms the light shield pattern BSM.

The pad 120 and the conductive adhesive member 300 may electrically connect the circuit board 200 and the electrode pattern 110, and the circuit board 200 and the wires 130.

The pad 120 may include a first pad 120a arranged on the electrode pattern 110, and a second pad 120b and a third pad 120c arranged on the insulating layer 160. Additionally, the first pad 120a, the second pad 120b, and the third pad 120c may be arranged along the X-axis direction. In this case, two first pads 120a, two second pads 120b, and one third pad 120c may be electrically connected to one circuit board 200, without being limited thereto. Here, the first pad 120a may be composed of a plurality of first pad wires 121. In addition, the second pad 120b may be composed of a plurality of second pad wires 122. Further, the third pad 120c may be composed of a plurality of third pad wires 123.

The plurality of first pad wires 121, second pad wires 122, and third pad wires 123 may be arranged in the Y-axis direction and may be arranged to be spaced apart from each other in the X-axis direction.

The plurality of first pad wires 121, second pad wires 122, and third pad wires 123 may be formed together with the gate electrode GE1 of the first TFT TFT1 and/or the gate electrode GE2 of the second TFT TFT2 during a mask process that forms one of the gate electrode GE1 of the first TFT TFT1 and the gate electrode GE2 of the second TFT TFT2, without being limited thereto.

The plurality of first pad wires 121 may be spaced apart at intervals of a first interval D1 and may be formed to have a first width W1. Here, the first interval D1 may be smaller than the second interval D2 between second pad wires 122. Additionally, the first width W1 may be smaller than the second width W2 between second pad wires 122. Further, the plurality of first pad wires 121 may be densely arranged in a limited space at one edge of the electrode pattern 110. Hence, since the first pad 120a is formed as a plurality of wires, unlike the pad provided in a plate shape, the current density at the first pad 120a may increase, and the temperature at the first pad 120a may increase correspondingly.

The plurality of second pad wires 122 may be arranged to be spaced apart by a second interval D2, and each second pad wire 122 may be formed to have a second width W2. Here, the second interval D2 may be formed to be larger than the first interval D1, and the second width W2 may be wider than the first width W1. Consequently, the temperature at the second pad 120b including a plurality of second pad wires 122 may be relatively lower than that at the first pad 120a including a plurality of first pad wires 121, without being limited thereto. For example, the temperature at the second pad 120b may vary depending on the second interval D2 and the second width W2 for the second pad wires 122.

The second pad wires 122 may be electrically connected to the first wire 131 constituting a plurality of wires 130. Here, the first wire 131 may be a driving line that applies a driving voltage signal to the display area DA of the display panel 100. In this case, the driving voltage may be, but not limited to, a high-potential voltage.

The plurality of third pad wires 123 may be arranged to be spaced apart from each other by the first interval D1 that is the same as the case of the first pad wires 121, and each third pad wire 123 may be formed to have the first width W1, without being limited thereto.

The third pad wires 123 may be electrically connected to the second wire 132 constituting a plurality of wires 130. Here, the second wire 132 may be a data line that applies a data voltage signal to the display area DA of the display panel 100.

The voltage applied to the third pad wire 123 through the third pad 120c may be a voltage that changes on the basis of a frame implemented in the display device, and the voltage applied to the first pad 120a and the second pad 120b may be a constant voltage having a relatively higher voltage level than the voltage applied through the third pad 120c. Consequently, the temperature at the third pad 120c may be relatively lower than the temperature at the first pad 120a.

The plurality of wires 130 may include a first wire 131 and a second wire 132. Here, the first wires 131 may be connected to the second pad wires 122. Additionally, the second wire 132 may be connected to the third pad wires 123.

The first wire 131 may be a driving line that applies a driving voltage signal to the display area DA of the display panel 100, and the second wire 132 may be a data line that applies a data voltage signal to the display area DA of the display panel 100, without being limited thereto.

The alignment mark 150 may be arranged between the first pad 120a and the second pad 120b. Hence, the first pad 120a may be spaced apart by a preset distance from the second pad 120b due to the alignment mark 150, so that the influence of the heat generated from the second pad 120b on the first pad 120a may be reduced in correspondence to the distance. Therefore, the alignment mark 150 arranged between the first pad 120a and the second pad 120b may reduce the temperature rise at the first pad 120a. Here, a conductive encapsulation film 180 may be placed on the alignment mark 150.

The insulating layer 160 may be arranged on the substrate 10, and the second pad 120b and the third pad 120c may be arranged on the insulating layer 160.

The insulating layer 160 may include organic and/or inorganic insulating materials, and may be formed as a single layer or multiple layers. For example, the organic insulating material may include acrylic resin or photosensitive polyimide, but not limited thereto. For example, the inorganic insulating materials may include a silicon oxide (SiOx) film or a silicon nitride (SiNx) film, but not limited thereto. For example, the insulating layer 160 may be formed together with at least one of the first buffer layer BUF1, the second buffer layer BUF2, the first gate insulating layer GI1, and the second gate insulating layer GI2 when the at least one is formed.

The overcoat layer 170 may be arranged on the electrode pattern 110. Here, the overcoat layer 170 may cover a part of the electrode pattern 110. So, a part of the electrode pattern 110 where the overcoat layer 170 is not arranged may be exposed to the outside. For example, the overcoat layer 170 may be not arranged on the part of the electrode pattern 110 overlapping with the first pad 120a.

The overcoat layer 170 may include organic and/or inorganic insulating materials, and may be formed as a single layer or multiple layers. For example, the overcoat layer 170 may be formed together with at least one of the organic insulating layer PCL, the first inorganic insulating layer PAS1, and the second inorganic insulating layer PAS2 when the at least one is formed.

The conductive encapsulation film 180 may cover the pad 120. Here, the conductive encapsulation film 180 covering the pad 120 with respect to the display panel 100 may be exposed to the outside. For example, when only the display panel 100 is supplied to the user, the conductive encapsulation film 180 covering the pad 120 may be exposed to the outside. Additionally, a conductive adhesive member 300 may be arranged on the conductive encapsulation film 180 covering the pad 120.

In addition, the conductive encapsulation film 180 may cover the alignment mark 150. Here, the conductive encapsulation film 180 may be exposed to the outside. For example, the conductive encapsulation film 180 arranged on the alignment mark 150 may be exposed to the outside. Specifically, since the conductive adhesive member 300 may be arranged only on the pad 120, the conductive encapsulation film 180 arranged on the alignment mark 150 may be exposed to the outside.

The conductive encapsulation film 180 may function as a passage through which a current flows while also functioning an encapsulation material. Hence, the conductive encapsulation film 180 may protect the constituent arranged under the conductive encapsulation film 180. Additionally, the conductive encapsulation film 180 may allow a current to flow between the constituent arranged above the conductive encapsulation film 180 and the constituent arranged under the conductive encapsulation film 180.

The conductive encapsulation film 180 may prevent the pad 120 and the alignment mark 150 from being damaged by a post-process that is performed after formation of the pad 120 and alignment mark 150. For example, the conductive encapsulation film 180 may protect the pad 120 and the alignment mark 150 from the etching solution used in the photoresist process. For example, if the conductive encapsulation film 180 is not present on the alignment mark 150, the alignment mark 150 may be lost due to the etching solution. Hence, the conductive encapsulation film 180 may prevent the alignment mark 150 from being lost by the post-process. The conductive encapsulation film 180 may also prevent the first pad wires 121, the second pad wires 122, and the third pad wires 123 from being lost.

The conductive encapsulation film 180 may be made of a conductive material having corrosion resistance (or, chemical resistance) to an etching solution. For example, the conductive encapsulation film 180 may include, but not limited to, one of chromium (Cr), aluminum (Al), platinum (Pt), gold (Ag), nickel (Ni), iron (Fe), indium (In), tin (Sn), and copper (Cu), and/or an alloy thereof. For example, the conductive encapsulation film 180 may be made of transparent indium tin oxide (ITO) like the cathode electrode CAT.

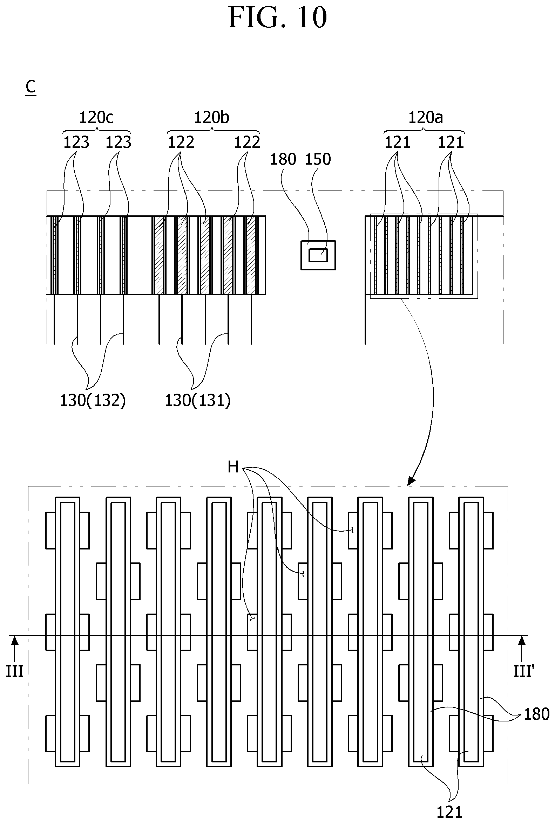

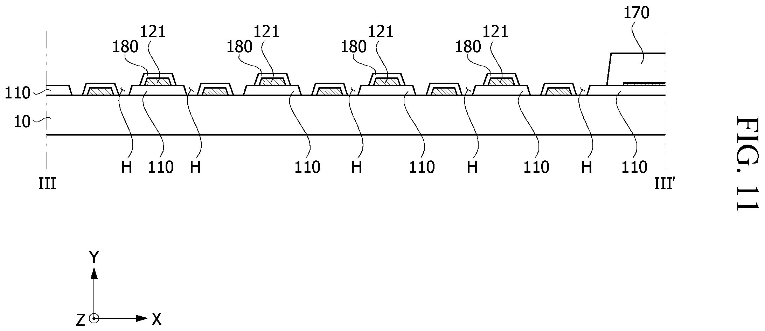

FIG. 10 is a view illustrating holes of the electrode pattern arranged in the display panel with respect to region C of FIG. 6 according to an exemplary embodiment of the present disclosure. FIG. 11 is a cross-sectional view taken along line III-III' of FIG. 10.

Referring to FIGS. 10 and 11, the electrode pattern 110 arranged in the display panel 100 may include a plurality of holes H. Here, the holes H may penetrate the electrode pattern 110 in the Z-axis direction.

The holes H may overlap with the first pad wires 121 of the first pad 120a. For example, one first pad wire 121 may overlap with at least two holes H. Hence, the test equipment positioned in correspondence to the holes H may check whether the circuit board 200 and the first pad 120a are normally attached, through the holes H. For example, when pressure is applied to the anisotropic conductive film together with a specific amount of heat, an impression may be formed on the first pad wires 121. In this case, the test equipment may identify whether the circuit board 200 and the first pad 120a are normally attached by checking the impression through the holes H.

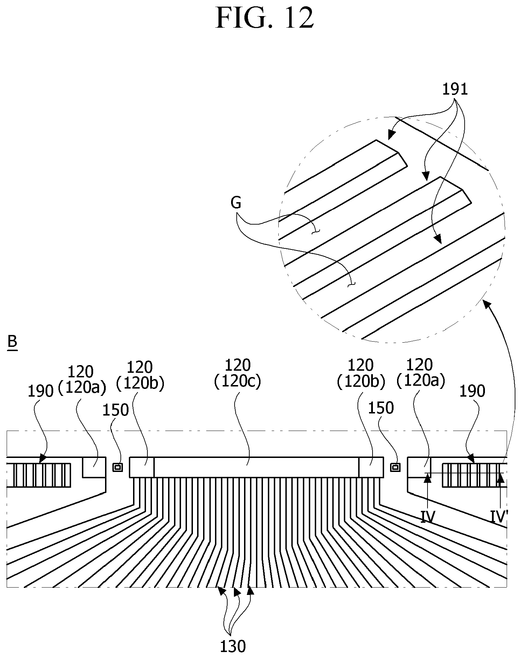

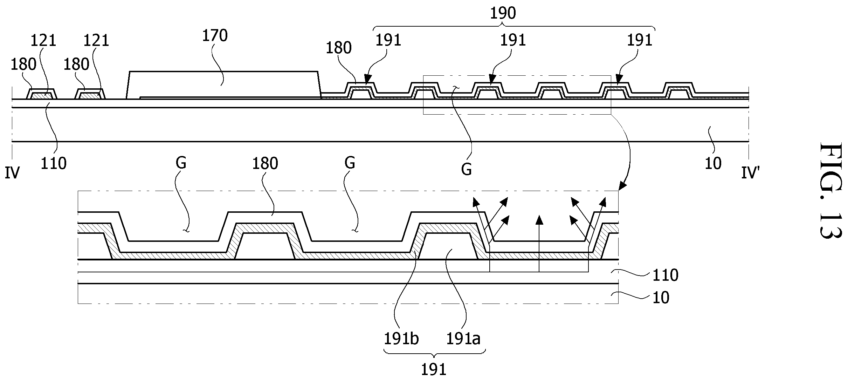

FIG. 12 is a view illustrating a heat dissipator arranged on the electrode pattern with respect to region B shown in FIG. 4. FIG. 13 is a cross-sectional view taken along line IV-IV' in FIG. 12. The arrow shown in FIG. 13 may indicate a heat transfer path.

The display device according to the present disclosure may include a heat dissipation structure arranged on the electrode pattern 110. For example, the heat dissipation structure may dissipate heat transferred to the electrode pattern 110. Here, since the heat dissipation structure may be exposed to the outside, the heat transferred from the first pad 120a to the electrode pattern 110 may be dissipated to the outside through the heat dissipation structure.

Referring to FIGS. 12 and 13, the display panel 100 may include a heat dissipator 190 disposed on the electrode pattern 110 and exposed to the outside. Here, the heat dissipator 190 may include a heat dissipation structure that dissipates heat transferred to the electrode pattern 110 to the outside. Hence, for efficient dissipation of the heat transferred to the electrode pattern 110, the heat dissipator 190 may be arranged adjacent to the electrode pattern 110. Here, the heat dissipator 190 may be arranged adjacent to the first pad 120a. Additionally, a conductive encapsulation film 180 may be arranged on the heat dissipator 190.

The heat dissipator 190 may be formed with an uneven structure. For example, the heat dissipator 190 may be composed of protruding patterns 191 arranged to be spaced apart from each other. Here, the protruding patterns 191 may be formed to protrude to have a specific height on the electrode pattern 110. So, grooves G may be formed between the protruding patterns 191.

The protruding patterns 191 may be formed in a bar shape having a specific height. Hence, since grooves G may be formed between multiple protruding patterns 191, the protruding pattern 191 may form a ridge of the uneven structure, and the groove G may form a valley of the uneven structure. Here, the ridge may represent a protruding portion, and the valley may represent a sunken portion.

The protruding patterns 191 may be arranged to be in contact with the electrode pattern 110, and may include a layer of metal material in contact with the electrode pattern 110.

The protruding pattern 191 may include a first layer 191a and a second layer 191b arranged on the first layer 191a, which are spaced apart from each other. Here, the second layer 191b may cover the first layer 191a.

The first layer 191a may include organic and/or inorganic insulating materials, and may be formed as a single layer or multiple layers. For example, the first layer 191a may include the same material as the insulating layer 160, and may be formed together with the insulating layer 160 when forming the insulating layer 160.

The first layer 191a may be formed to have a specific height on the electrode pattern 110. Consequently, the first layer 191a may increase the area of the second layer 191b exposed to the outside.

The second layer 191b may include a metal material, and one side of the second layer 191b may come into contact with the electrode pattern 110. Consequently, the heat transferred from the first pad 120a to the electrode pattern 110 may be dissipated to the outside through the second layer 191b (see arrows shown in FIG. 13). Here, the heat dissipation area of the second layer 191b may be adjusted according to the size of the first layer 191a.

As shown in FIG. 13, two second layers 191b covering two first layers 191a arranged adjacent to each other are connected to each other, without being limited thereto. For example, if the second layer 191b may contact the electrode pattern 110, the second layers 191b that are arranged adjacent to each other may be disconnected. For example, two second layers 191b arranged respectively on two adjacent protruding patterns 191 may be disconnected between two first layers 191a arranged adjacent to each other.

The second layer 191b may include a metal material, and may be formed as, but not limited to, a single layer or multiple layers. For example, the second layers 191b may be formed together with the pad wires 121, 122 and 123 during a mask process for forming the pad wires 121, 122 and 123, without being limited thereto.

The display device according to one or more exemplary embodiments of the present disclosure may be described as follows.

A display device according to one or more exemplary embodiments of the present disclosure may include a display panel and a plurality of circuit boards connected to the display panel, wherein the display panel may include an electrode pattern arranged on a substrate and a pad electrically connected to the circuit boards, wherein the pad may include a first pad arranged on the electrode pattern to overlap therewith, and wherein the first pad may include a plurality of first pad wires arranged to be spaced apart from each other.

According to one or more exemplary embodiments of the present disclosure, the display panel may further include a conductive encapsulation film covering the plurality of first pad wires.

According to one or more exemplary embodiments of the present disclosure, the electrode pattern may be formed in a plate shape, and the plurality of first pad wires may overlap with the electrode pattern in a first direction and a second direction.

According to one or more exemplary embodiments of the present disclosure, the electrode pattern may include a plurality of holes, and the holes may overlap with the first pad wires.

According to one or more exemplary embodiments of the present disclosure, the pad may include a first pad and a second pad arranged to be spaced apart from each other, and the display panel may further include an alignment mark arranged between the first pad and the second pad.

According to one or more exemplary embodiments of the present disclosure, the display panel may further include a conductive encapsulation film covering the alignment mark.

According to one or more exemplary embodiments of the present disclosure, the display panel may further include a heat dissipator arranged on the electrode pattern.

According to one or more exemplary embodiments of the present disclosure, the heat dissipator may include a plurality of protruding patterns arranged to be spaced apart from each other on the electrode pattern, and the protruding patterns may be exposed to the outside.

According to one or more exemplary embodiments of the present disclosure, the protruding patterns (e.g., each of the protruding patterns) may include a first layer made of an insulating material and arranged on the electrode pattern, and a second layer made of a metal material and arranged on the first layer, wherein a portion of the second layer may be in contact with the electrode pattern.

According to one or more exemplary embodiments of the present disclosure, the display panel may further include a conductive encapsulation film covering the plurality of protruding patterns.

According to one or more exemplary embodiments of the present disclosure, the electrode pattern may be electrically connected to a cathode electrode arranged on the substrate.

According to one or more exemplary embodiments of the present disclosure, the display panel may further include an overcoat layer arranged on the electrode pattern, and the overcoat layer may be not arranged on a portion of the electrode pattern overlapping with the first pad.

A display device according to one or more exemplary embodiments of the present disclosure may include a display panel and a plurality of circuit boards connected to the display panel, wherein the display panel may include an electrode pattern arranged on a substrate, a first pad and a second pad electrically connected to the circuit boards, and an alignment mark arranged between the first pad and the second pad, and wherein the first pad may overlap with the electrode pattern.

According to one or more exemplary embodiments of the present disclosure, the display panel may further include a conductive encapsulation film covering the alignment mark.

According to one or more exemplary embodiments of the present disclosure, the first pad may include a plurality of first pad wires arranged to be spaced apart from each other, the second pad may include a plurality of second pad wires arranged to be spaced apart from each other, and the plurality of first pad wires may overlap with the electrode pattern.

According to one or more exemplary embodiments of the present disclosure, the electrode pattern may include a plurality of holes, wherein the holes may overlap with the first pad wires.

According to one or more exemplary embodiments of the present disclosure, the plurality of first pad wires may be spaced apart at intervals of a first interval and each first pad wire may be formed to have a first width, and the plurality of second pad wires may be arranged to be spaced apart by a second interval, and each second pad wire may be formed to have a second width.

According to one or more exemplary embodiments of the present disclosure, the second interval may be larger than the first interval, and the second width may be wider than the first width.

According to one or more exemplary embodiments of the present disclosure, the display panel may further include a heat dissipator arranged on the electrode pattern.

According to one or more exemplary embodiments of the present disclosure, the heat dissipator may include a plurality of protruding patterns arranged to be spaced apart from each other on the electrode pattern, and the protruding patterns may be exposed to the outside.

According to one or more exemplary embodiments of the present disclosure, the protruding patterns may include a first layer made of an insulating material and arranged on the electrode pattern (110), and a second layer made of a metal material and arranged on the first layer, and a portion of the second layer may be in contact with the electrode pattern.

A display device according to one or more exemplary embodiments of the present disclosure may include a display panel and a plurality of circuit boards connected to the display panel, wherein the display panel may include an electrode pattern arranged on a substrate, a pad electrically connected to the circuit boards, and a heat dissipator arranged on the electrode pattern, wherein the pad may include a first pad arranged on the electrode pattern to overlap therewith, and wherein the heat dissipator may be arranged adjacent to the first pad.

According to one or more exemplary embodiments of the present disclosure, the heat dissipator may include a plurality of protruding patterns arranged to be spaced apart from each other on the electrode pattern.

According to one or more exemplary embodiments of the present disclosure, the protruding pattern may include a first layer made of an insulating material and arranged on the electrode pattern, and a second layer made of a metal material and arranged on the first layer, wherein a portion of the second layer may be in contact with the electrode pattern.

According to one or more exemplary embodiments of the present disclosure, the display panel may further include a conductive encapsulation film covering the plurality of protruding patterns, wherein the conductive encapsulation film may be exposed to the outside.

According to one or more exemplary embodiments of the present disclosure, the first pad may include a plurality of first pad wires arranged to be spaced apart from each other, the electrode pattern may include a plurality of holes, the plurality of first pad wires may overlap with the electrode pattern, and the holes may overlap with the first pad wires.

A display panel according to one or more exemplary embodiments of the present disclosure may include an electrode pattern disposed on a substrate and a pad electrically connected to circuit boards, wherein the pad may include a first pad arranged on the electrode pattern to overlap therewith, and wherein the first pad may include a plurality of first pad wires arranged to be spaced apart from each other.

A display panel according to one or more exemplary embodiments of the present disclosure may include an electrode pattern arranged on a substrate, a first pad and a second pad electrically connected to the circuit boards, and an alignment mark arranged between the first pad and the second pad, and wherein the first pad may overlap with the electrode pattern.

A display panel according to one or more exemplary embodiments of the present disclosure may include an electrode pattern arranged on a substrate, a pad electrically connected to the circuit boards, and a heat dissipator arranged on the electrode pattern, wherein the pad may include a first pad arranged on the electrode pattern to overlap therewith, and wherein the heat dissipator may be arranged adjacent to the first pad.

**LIST OF REFERENCE NUMBERS**

| | | | |
|---|---|---|---|
| 10: | Substrate | 100: | Display panel |
| 110: | Electrode pattern | 120: | Pad |
| 120a: | First pad | 120b | Second pad |
| 120c: | Third pad | 121: | First pad wires |
| 122: | Second pad wires | 123: | Third pad wires |
| 130: | Wires | 150: | Alignment mark |
| 160: | Insulating layer | 170: | Overcoat layer |
| 180: | Conductive encapsulation film | | |
| 190: | Heat dissipator | 200: | Circuit board |
| 300: | Adhesive member | CAT: | Cathode electrode |

The various embodiments described above can be combined to provide further embodiments.

## Claims

1. A display device comprising:
a display panel (100); and
a plurality of circuit boards (200) connected to the display panel (100),
wherein the display panel (100) includes a substrate (10), an electrode pattern (110) arranged on the substrate (10), and a pad (120) connected to the circuit boards (200),
wherein the pad (120) includes a first pad (120a) arranged on the electrode pattern (110) to overlap with the electrode pattern (110), and
wherein the first pad (120a) includes a plurality of first pad wires (121) arranged to be spaced apart from each other.

2. The display device of claim 1, wherein the display panel (100) further includes a conductive encapsulation film (180) covering the plurality of first pad wires (121).

3. The display device of claim 1 or 2, wherein,
the electrode pattern (110) is formed in a plate shape, and
the plurality of first pad wires (121) overlap with the electrode pattern (110) in a first direction and a second direction.

4. The display device of any of claims 1 to 3, wherein,
the electrode pattern (110) includes a plurality of holes (H); and
the plurality of holes (H) overlap with the first pad wires (121).

5. The display device of any of claims 1 to 4, wherein,
the pad (120) comprises a first pad (120a) and a second pad (120b) arranged to be spaced apart from each other, and
the display panel (100) further includes an alignment mark (150) arranged between the first pad (120a) and the second pad.

6. The display device of claim 5, wherein the second pad (120b) includes a plurality of second pad wires (122) arranged to be spaced apart from each other.

7. The display device of claim 6, wherein,
the plurality of first pad wires (121) are spaced apart at intervals of a first interval (D1), and each first pad wire (121) has a first width (W1), and
the plurality of second pad wires (122) are arranged to be spaced apart by a second interval (D2), and each second pad wire (122) has a second width (W2),
wherein, preferably, the second interval (D2) is larger than the first interval (D1), and the second width (W2) is wider than the first width (W1)

8. The display device of any of claims 5 to 7, wherein the display panel (100) further includes a conductive encapsulation film (180) covering the alignment mark (150).

9. The display device of any of claims 1 to 8, wherein the display panel (100) further includes a heat dissipator (190) arranged on the electrode pattern (110).

10. The display device of claim 9, wherein the heat dissipator (190) is arranged adjacent to the first pad (120a).

11. The display device of claim 9 or 10, wherein,
the heat dissipator (190) includes a plurality of protruding patterns (191) arranged to be spaced apart from each other on the electrode pattern (110), and
the plurality of protruding patterns (191) are exposed to an outside.

12. The display device of claim 11, wherein,
the protruding patterns (191) include a first layer (191a) made of an insulating material and arranged on the electrode pattern (110), and a second layer (191b) made of a metal material arranged on the first layer (191a), and
a portion of the second layer (191b) is in contact with the electrode pattern (110).

13. The display device of claim 11 or 12, wherein the display panel (100) further includes a conductive encapsulation film (180) covering the plurality of protruding patterns (191).

14. The display device of any of claims 1 to 13, further comprising a cathode electrode (CAT) arranged on the substrate (10), wherein the electrode pattern (110) is electrically connected to the cathode electrode (CAT).

15. The display device of any of claims 1 to 14, wherein the display panel (100) further includes an overcoat layer (170) arranged on the electrode pattern (110), and
wherein the overcoat layer (170) is not arranged on a portion of the electrode pattern (110) overlapping with the first pad (120a).
